# EUROPEAN PATENT APPLICATION

(11) **EP 4 728 942 A1**
(43) Date of publication of application: **22.04.2026**
(21) Application number: 25150753.9
(22) Date of filing: 08.01.2025
(51) Int. Cl.: A47J 37/06

(54) **COOKING SYSTEM**

(30) Priority: 17.10.2024 CN 202411453490
(71) Applicant: Huayu Electrical Appliance Group Co., Ltd., Ningbo, Zhejiang (CN)
(72) Inventor: XU, JIASHENG, Ningbo (CN); LI, HAIFENG, Ningbo (CN); DU, LIUSHENG, Ningbo (CN)
(74) Representative: Metida

(57) **Abstract**

The cooking system includes a pot body, the pot body has a first cooking cavity and a second cooking cavity which are arranged with one below the other. Fan assemblies are correspondingly mounted on the back of the first cooking cavity and the back of the second cooking cavity, and each fan assembly includes a cold air fan and a hot air fan. Cold air ducts connected to the outside are formed between the first cooking cavity and the pot body and between the second cooking cavity and the pot body. Hot air ducts are formed between the first cooking cavity and an air fryer placed in the first cooking cavity and/or between the second cooking cavity and an air fryer placed in the second cooking cavity.

## Description

### CROSS-REFERENCE TO RELATED APPLICATIONS

This application claims priority to Chinese Patent Application No. 202411453490.0, filed on October 17, 2024, the content of which is incorporated herein by reference in its entirety.

### TECHNICAL FIELD

The present application relates to the technical field of cookware, in particular to a cooking system.

### BACKGROUND

Air fryers cook food mainly by means of air rather than hot oil in frying pans, and water is blown away from the surface of the food by hot air to fulfill an approximate frying effect on the food. Based on "high-speed air circulation", the air fryer generates hot air by means of heating tubes in a high-temperature heater and then blows the hot air into a pot to heat food by means of a fan, and the hot air circulates in an enclosed space to fry the food by means of grease of the food, such that water is removed from the food until the surface of the food becomes golden and crispy, thus fulfilling a frying effect.

In the prior art, air fryers, especially air fryers with two pots that are arranged with one below the other, not only have higher working efficiency, but also can prevent air flow between the two pots, that is, food in one pot is prevented from being tainted by odor in the other pot. In some air fryers, to adapt to the arrangement of two pots with one below the other, an air inlet assembly is arranged on one side of the air fryer to deliver hot air into corresponding baskets laterally to cook food. By adopting such a technical solution, the use of two ports that are arranged with one below the other can be realized to some extent; however, due to the hot air flow path and the air inlet angle, food cannot be uniformly heated by the hot air supplied laterally, and the cooking efficiency needs to be further improved.

In actual use, particularly in long-term operation, of the air fryers, the structure between the two pots may be heated up, and a high-temperature dead corner may be formed, leading to thermal deformation, peptization and other anomalies at this position.

### SUMMARY

The objective of the present application is to provide a cooking system, which is provided with cold air ducts and hot air ducts and can heat food uniformly.

To fulfill the above objective, the present application adopts the following technical solution.

A cooking system comprises a pot body, wherein the pot body has a first cooking cavity and a second cooking cavity which are arranged with one below the other, fan assemblies are correspondingly mounted on a back of the first cooking cavity and a back of the second cooking cavity, and each fan assembly comprises a cold air fan and a hot air fan; cold air ducts connected to an outside are formed between the first cooking cavity and the pot body and between the second cooking cavity and the pot body; hot air ducts are formed between the first cooking cavity and an air fryer placed in the first cooking cavity and/or between the second cooking cavity and an air fryer placed in the second cooking cavity; part of the air is drawn into the fan assemblies from a bottom of the pot body and delivered into the cold air ducts by means of the cold air fans; and the hot air fans are used for driving air in the hot air ducts to circulate between the air fryers and the hot air ducts to cook food.

The principle and advantages of the present application are as follows: the fan assemblies are arranged on the back of the pot body and each fan assembly comprises a cold air fan and hot air fan, such that the hot air ducts and the cold air ducts are formed to cook food and cool some structures; the first cooking cavity and the second cooking cavity are formed in the pot body, such that two pots can be placed in the first cooking cavity and the second cooking cavity respectively, and air flow between the two pots is prevented during cooking, that is, food in one pot is prevented from being stained by odor in the other pot; part of the air is drawn into the fan assemblies from the bottom of the pot body and then delivered to the cold air ducts by means of the cold air fans, such that a temperature rise of corresponding structures of the fan assemblies can be controlled, and air drawn from the bottom of the pot body can flow at the bottom of the pot body to reduce the temperature of the bottom of the pot body.

Preferably, as an improvement, duct plate assemblies are arranged at a top of the first cooking cavity and a top of the second cooking cavity, heating elements are arranged in the duct plate assemblies, and air directors are connected between the fan assemblies and the duct plate assemblies.

Beneficial effect: by adopting the above technical solution, air is heated when flowing through the heating elements, and air circulation is realized under the combined action of the fan assemblies, the air directors, the duct plate assemblies and the air fryers, that is, high-temperature air circulates between the air fryers and the hot air ducts to cook food.

Preferably, as an improvement, each duct plate assembly comprises an upper duct plate and a lower duct plate, and air is blown into the first cooking cavity or the second cooking cavity sequentially through the corresponding air director, the corresponding upper duct plate and the corresponding lower duct plate.

Beneficial effect: by adopting the above technical solution, air can be directed smoothly to be blown into the first cooking cavity or the second cooking cavity more reasonably, such that air is unlikely to be blocked in the flowing process.

Preferably, as an improvement, each fan assembly comprises a housing, a driving component is mounted in the housing, the cold air fan and the hot air fan are located on two sides of the driving component respectively, and the hot air fan is arranged close to the first cooking cavity or the second cooking cavity and located in the corresponding air director; and air inlets are formed in the bottom of the pot body and connected to a side of one housing to form an air inlet path.

Beneficial effect: by adopting the above technical solution, the cold air fans and the hot air fans are arranged reasonably, that is, the cold air fans are isolated from and opposite to the hot air fans, such that the hot air ducts and the cold air ducts can be formed and used separately; and the air inlets are formed in the bottom of the pot body, such that cold air can be drawn into the pot body from the bottom and can be delivered into the cold air ducts more quickly.

Preferably, as an improvement, a rear cover plate is detachably connected to the pot body, cold air cavities are formed in the rear cover plate, and the cold air fans are arranged in the corresponding cold air cavities; cold air outlets are formed in side walls of the cold air cavities and connected to the cold air ducts; and exhaust outlets are formed in a side wall of the pot body and connected to the cold air ducts.

Beneficial effect: by adopting the above technical solution, the exhaust outlets have a guide effect, and cold air can be delivered into the cold air ducts quickly under the combined action of the cold air fans and the cold air cavities, thus improving the cooling efficiency and effect.

Preferably, as an improvement, a partition is arranged in the pot body, and the first cooking cavity and the second cooking cavity are located above and below the partition respectively.

Beneficial effect: by adopting the above technical solution, the pot body can be divided vertically to facilitate the arrangement or formation of the first cooking cavity and the second cooking cavity.

Preferably, as an improvement, partition ribs are arranged on the rear cover plate, and each partition rib partitions the corresponding cold air outlet into two portions with opposite flow directions.

Beneficial effect: by adopting the above technical solution, each cold air outlet can be divided by the corresponding partition rib into two portions corresponding to left and right sides of the overall structure of the cooking system, such that the temperature of the two sides of the structure can be reduced under the action of air.

Preferably, as an improvement, air deflectors are arranged at joints between the air directors and the upper duct plates.

Beneficial effect: by adopting the above technical solution, incoming air can be dispersed, that is, air is prevented from being excessively concentrated when flowing through the area between the upper duct plate and the lower duct plate, such that air can enter the first cooking cavity and the second cooking cavity relatively uniformly so as to be heated uniformly, that is, food to be cooked can be heated uniformly.

Preferably, as an improvement, a capacity of the first cooking cavity is greater than a capacity of the second cooking cavity, a receiving cavity is formed between the second cooking cavity and the pot body, and an operation panel corresponding to the receiving cavity is correspondingly mounted on the pot body.

Beneficial effect: the capacity of the first cooking cavity is different from the cooking cavity of the second cooking cavity, such that different air fryers can be used for cooking according to the quantity or type of food to be cooked; by means of the operation panel, users can easily adjust the cooking mode or parameters; and the receiving cavity is arranged for wire arrangement in the pot body.

Preferably, as an improvement, a top of the upper duct plate is inclined to allow a flow path of part of the air to deflect towards the first cooking cavity or the second cooking cavity, and the upper duct plate deviates from the corresponding heating element.

Beneficial effect: under the influence of the flow path of air blown into the first cooking cavity or the second cooking cavity, the situation that the food is over-cooked or fails to be fully cooked due to non-uniform heating of one side of the area where the food is located is avoided; and the upper duct plate deviates from the corresponding heating element, such that air can be blown into the first cooking cavity or the second cooking cavity relatively uniformly to realize uniform heating of food.

Preferably, as an improvement, a hot air outlet passage is connected between the two duct plate assemblies, and the hot air outlet passage is provided with a hot air outlet connected to the outside.

Beneficial effect: by adopting the above technical solution, surplus hot air can be discharged via the hot air outlet passage in actual use.

Preferably, as an improvement, suction holes are formed in the rear cover plate and correspond to the cold air fan of the fan assembly located above.

Beneficial effect: by adopting the above technical solutions, the corresponding fan assembly can suck air from the suction holes to blow cold air to the left and right sides of the cooking system as well as the top of the cooking system, such that the structural temperature of the cooking system is further reduced.

### BRIEF DESCRIPTION OF THE DRAWINGS

FIG. 1 is a schematic diagram of a cooking system according to the present application.
FIG. 2 is an exploded structural view according to the present application.
FIG. 3 is a longitudinal sectional structural view which illustrates an air flow path according to the present application.
FIG. 4 is a horizontal sectional structural view which illustrates the air flow path according to the present application.
FIG. 5 is an internal structural view according to the present application.
FIG. 6 is a schematic arrangement diagram of a first cooking cavity and a second cooking cavity according to the present application.
FIG. 7 is a schematic arrangement direction of the first cooking cavity and the second cooking cavity from another perspective according to the present application.
FIG. 8 is a schematic diagram of an air fryer according to the present application.

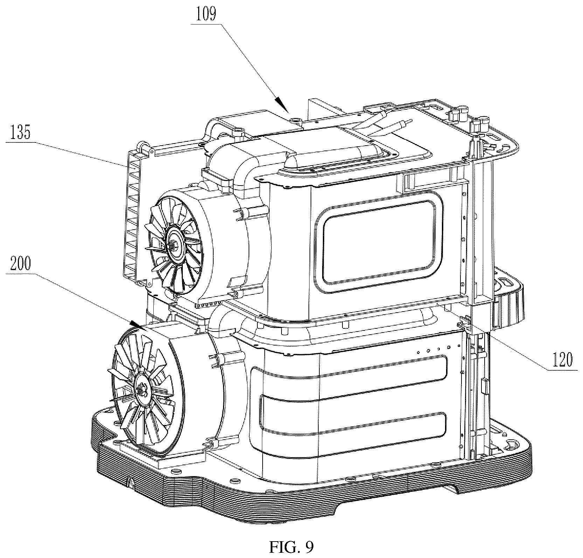

FIG. 9 is a schematic arrangement diagram of fan assemblies according to the present application.

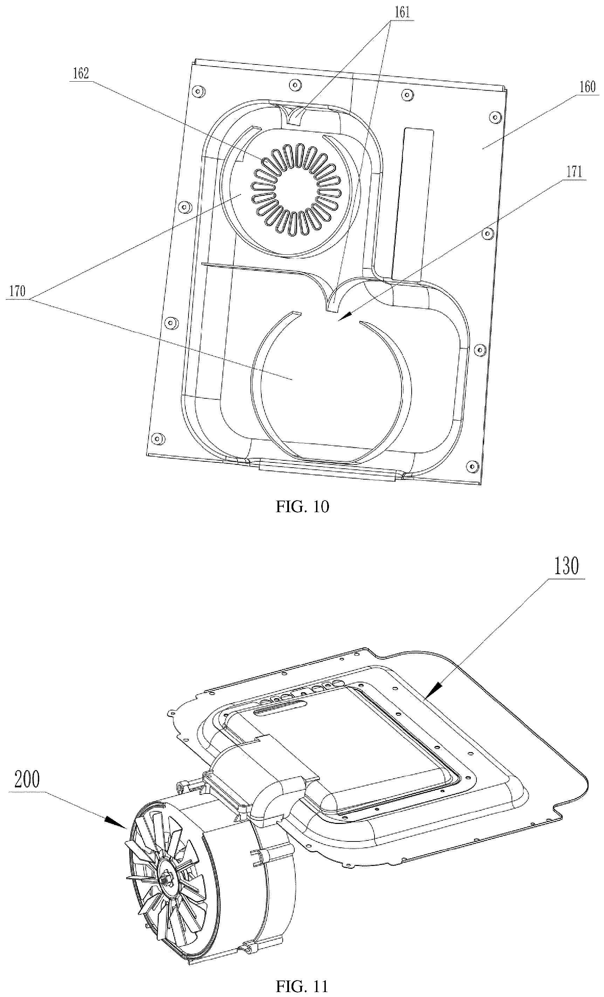

FIG. 10 is a schematic diagram of a rear cover plate according to the present application.
FIG. 11 is a schematic diagram of the connection relation between the fan assembly and a duct plate assembly according to the present application.

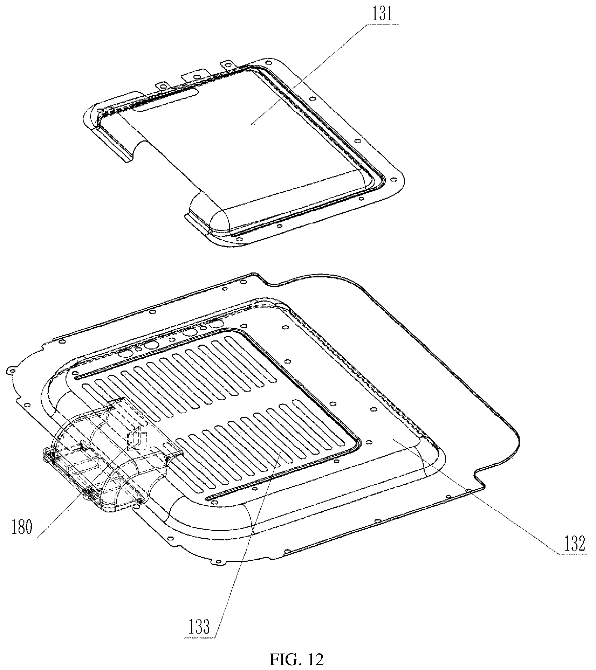

FIG. 12 is an exploded and perspective structural view of the air duct plate assembly according to the present application.

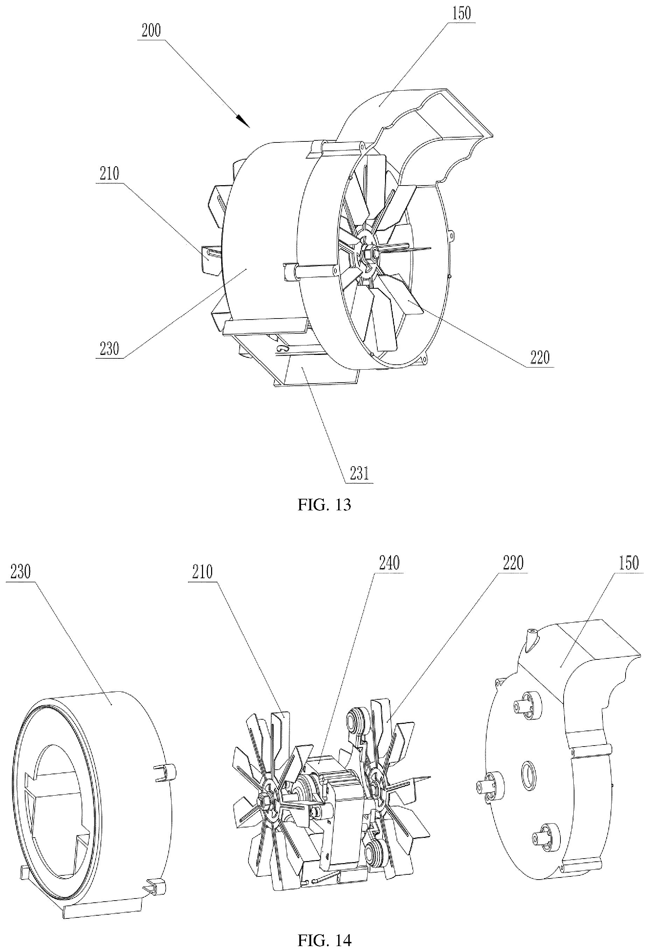

FIG. 13 is a schematic diagram of the fan assembly according to the present application.
FIG. 14 is an exploded structural view of the fan assembly according to the present application.

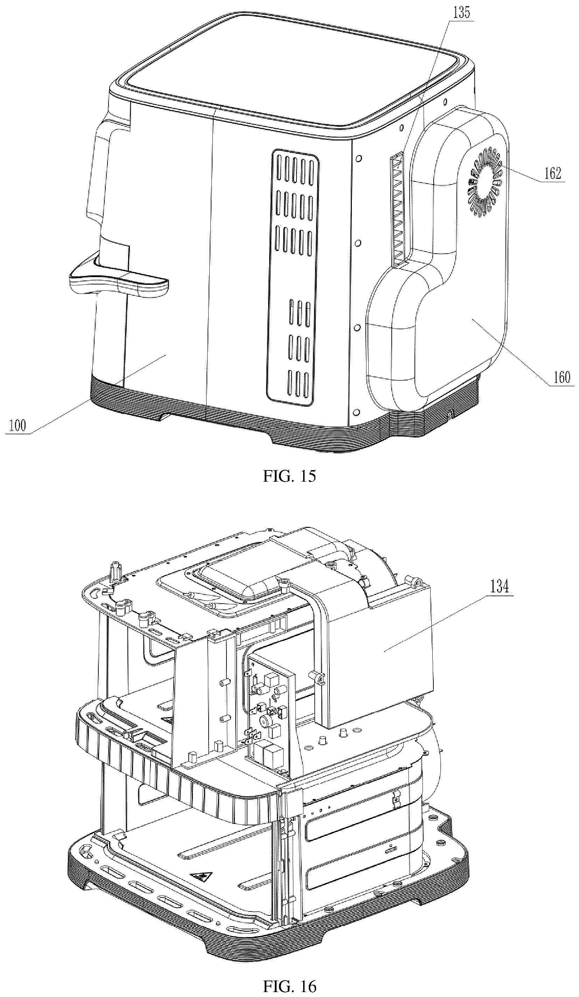

FIG. 15 is a back view according to the present application.
FIG. 16 is a schematic diagram of a hot air outlet passage according to the present application.

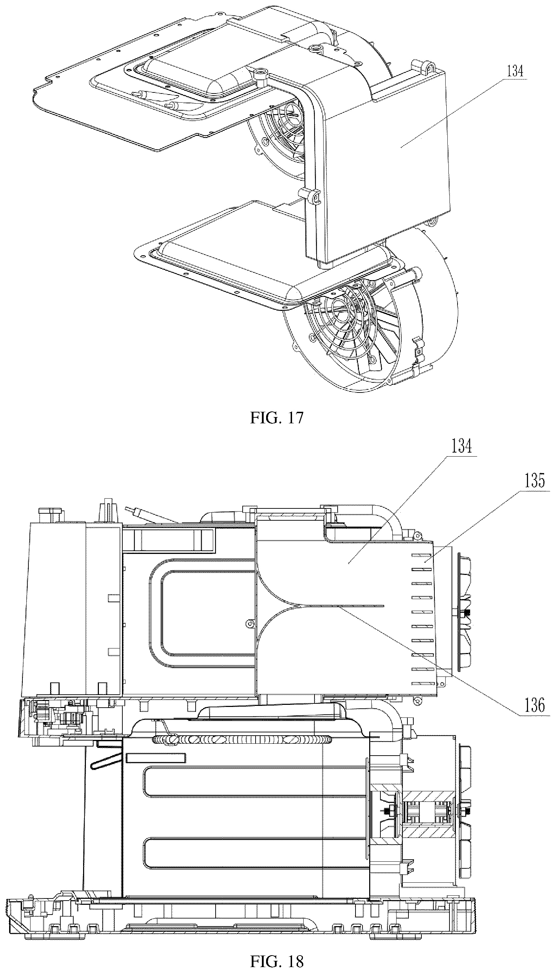

FIG. 17 is a schematic connection diagram of the hot air outlet passage and the duct plate assemblies according to the present application.
FIG. 18 is a sectional structural view of the hot air outlet passage according to the present application.

### DETAILED DESCRIPTION OF THE EMBODIMENTS

The present application is described in further detail below in conjunction with specific embodiments.

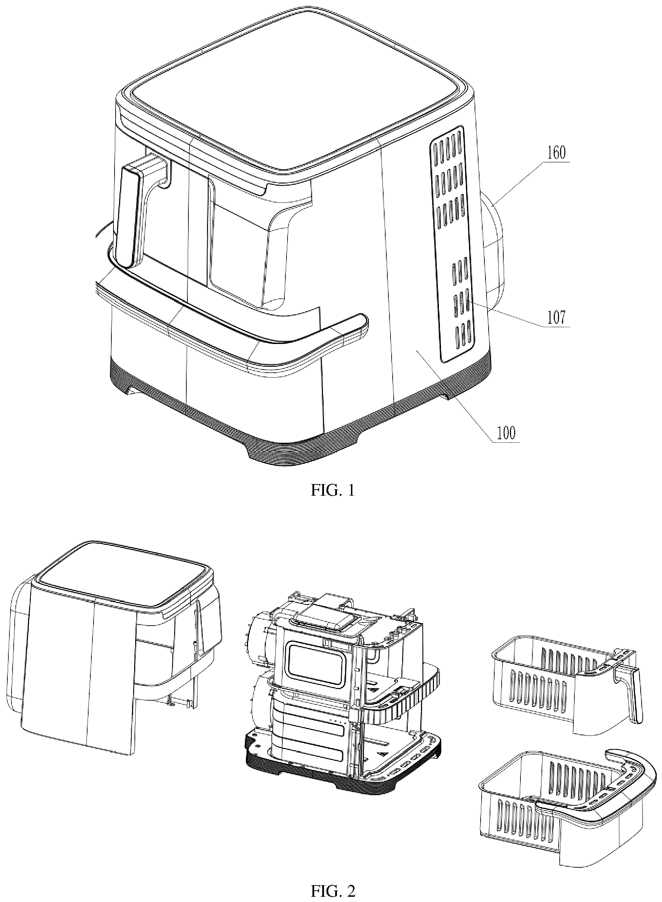

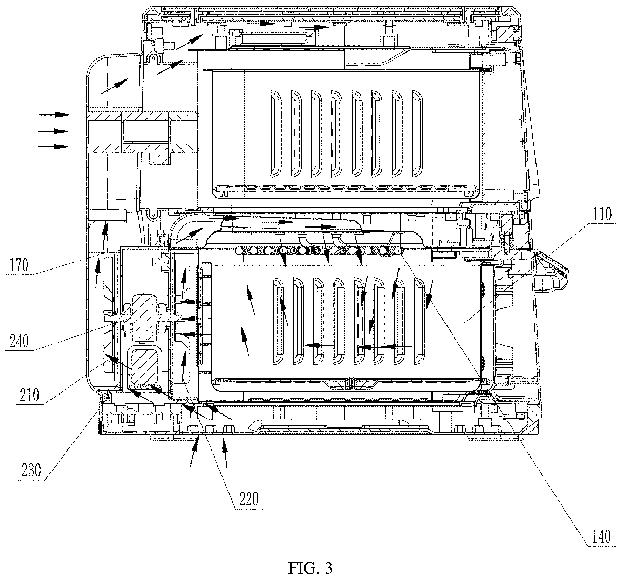

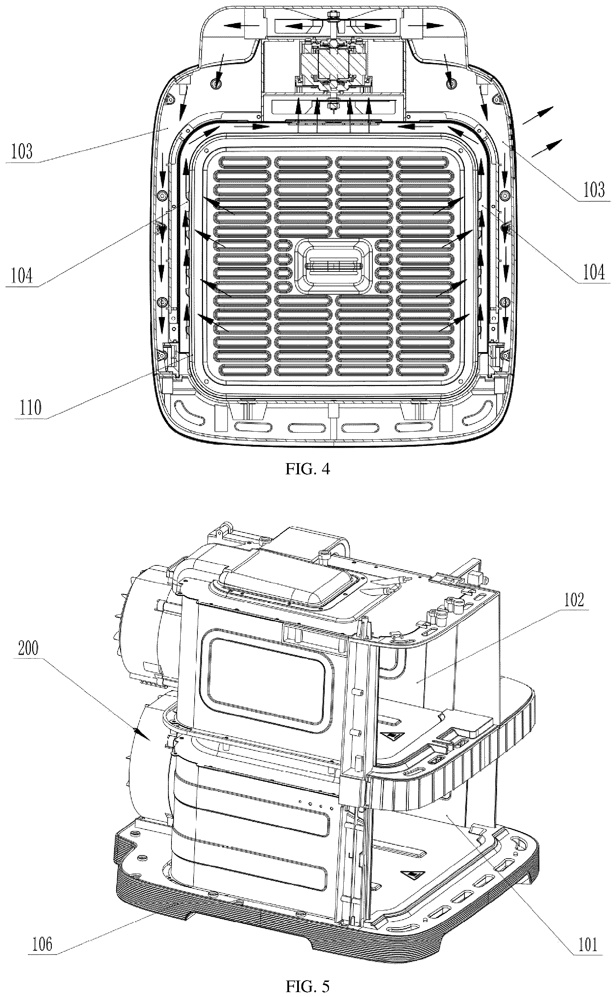

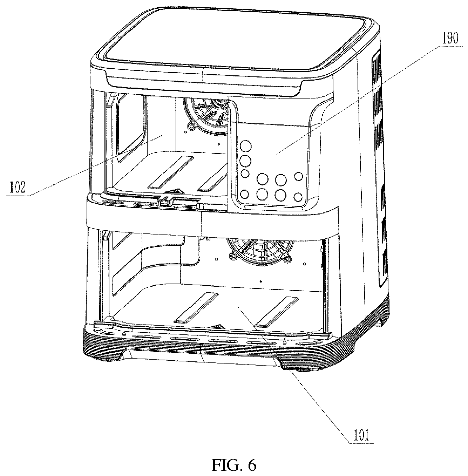

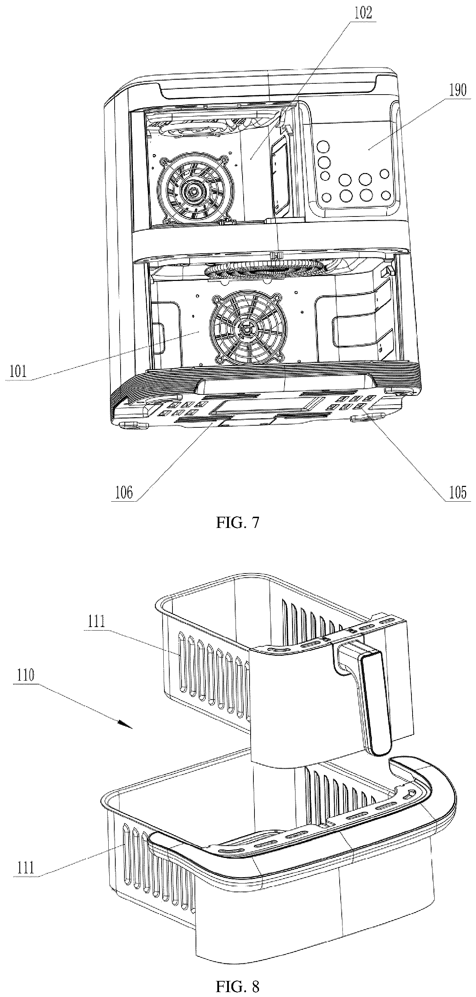

This embodiment is basically illustrated by FIGS. 1-8.

A cooking system comprises a pot body 100, wherein the pot body 100 has a first cooking cavity 101 and a second cooking cavity 102 which are arranged with one below the other, the first cooking cavity 101 is located below the second cooking cavity 102, and fan assemblies 200 are correspondingly mounted on a back of the first cooking cavity 101 and a back of the second cooking cavity 102.

Air fryers 110 are correspondingly arranged in the first cooking cavity 101 and the second cooking cavity 102.

To realize the arrangement of two cooking cavities with one below the other, a partition 120 is arranged in the pot body 100, the first cooking cavity 101 and the second cooking cavity 102 are located above and below the partition 120 respectively, that is, the partition 120 is horizontally arranged in the pot body 100, outer pots are correspondingly arranged on an upper portion and a lower portion of the pot body 100, and the first cooking cavity 101 and the second cooking cavity 102 are formed in areas defined by the corresponding outer pots.

In this embodiment, each fan assembly 200 comprises a cold air fan 210 and a hot air fan 220; cold air ducts 103 connected to the outside are formed between the first cooking cavity 101 and the pot body 100 and between the second cooking cavity 102 and the pot body 100; hot air ducts 104 are formed between the first cooking cavity 101 and the air fryer 110 placed in the first cooking cavity 101 and/or between the second cooking cavity 102 and the air fryer 110 placed in the second cooking cavity 101; part of the air is drawn into the fan assemblies 200 from the bottom of the pot body 100 and then delivered into the cold air ducts 103 by means of the cold air fans 210; and the hot air fans 220 are used for driving air in the hot air ducts 104 to circulate between the air fryers 110 and the hot air ducts 104 to cook food.

Circulating air vents 111 are formed in two side walls of each air fryer 110; and when the air fryer 110 is used for cooking food, hot air flows out the air fryer 110 via the circulating air vents 111 in two sides of the air fryer 110 and flows back to the hot air fan 110 through the hot air duct 104, and under the action of the hot air fan 110, the hot air circulates between the air fryer 110 and the hot air duct 104 to cook food.

Duct plate assemblies 130 are arranged at the top of the first cooking cavity 101 and the top of the second cooking cavity 102, heating elements 140 are arranged in the duct plate assemblies 130, air directors 150 are connected between the fan assemblies 200 and the duct plate assemblies 130, and preferably, the heating elements 140 are heating tubes.

Specifically, the air directors 150 are connected between ends, provided with the hot air fans 220, of the fan assemblies 200 and the duct plate assemblies 130.

In this embodiment, the duct plate assembly 130 comprises an upper duct plate 131 and a lower duct plate 132, and air is blown into the first cooking cavity 101 or the second cooking cavity 102 sequentially through the hot air duct 104, the hot air fan 220, the air director 150, the upper duct plate 131, the lower duct plate 132 and the heating element 140.

The top of the upper duct plate 131 is inclined to allow a flow path of part of the air to deflect towards the first cooking cavity 101 or the second cooking cavity 102; and the upper duct plate 131 deviates from the corresponding heating element 140, that is, a structural center of the upper duct plate 131 deviates from a structural center of the corresponding heating element 140.

The upper duct plate 131 is correspondingly mounted above the lower duct plate 132, the heating element 140 is arranged below the lower duct plate 132, multiple strip slots 133 are formed in the lower duct plate 132 and divided into two rows which are respectively located on left and right side of a hot air inflow direction, the direction of each strip slot 133 is perpendicular to the hot air inflow direction, and under the combined action of the strip slots 133 and the inclined top of the upper duct plate 131, the quantity of hot air flowing out from a front section of the lower duct plate 132 (a portion, away from the corresponding fan assembly 200, of the lower duct plate 132) is reduced, such that food can be heated uniformly on the whole, and the situation that the food is over-cooked or fails to be fully cooked due to non-uniform heating of one side of the area where the food is located is avoided.

To ensure that the hot air duct 104 and the cold air duct 103 can be formed separately when the cooking system operates, in this embodiment, the fan assembly 200 comprises a housing 230, wherein a driving component 240 is mounted in the housing 230, the cold air fan 210 and the hot air fan 220 are located on two sides of the driving component 240 respectively, and the hot air fan 220 is arranged close to the first cooking cavity 101 or the second cooking cavity 102 and located in the air director 150; and air inlets 105 are formed in the bottom of the pot body 100 and connected to one side of one housing 230, and specifically, the air inlets 105 are connected to one side of the housing 230 located below to form an air inlet path.

Preferably, the driving component 240 is a motor, and the motor has two output ends, that is, the cold air fan 210 and the hot air fan 220 are correspondingly mounted at the two output ends of the motor respectively; a suitable base 106 is arranged at the bottom of the pot body 100, the air inlets 105 are located in the base 106, a main structure of the base 106 is a hollow structure, the housings 230 are mounted on the base 106, suction inlets 231 are formed at joints between the housings 230 and the base 106; cold air is drawn into the fan assembly 200 located below from the outside of the cooking system via the air inlets 105, the hollow structure of the base 106, the corresponding suction inlet 231, the corresponding housing 230 and the corresponding cold air fan 210; and part of the cold air is drawn into the fan assembly 200 located above via the corresponding suction inlet 231, the corresponding housing 230 and the corresponding cold air fan 210. Based on the scheme that the driving components 240 are arranged in the housings 230 and air is drawn into the housings 230 via the air inlets 105 in the bottom of the pot body 100 and delivered into the cold air ducts 103 by means of the cold air fans 210, the driving components 240 can be cooled continuously, such that a temperature rise of the driving components 240 can be effectively controlled.

The driving component 240 is horizontally arranged on the whole, that is, an output shaft of the driving component 240 is perpendicular to the first cooking cavity 101 or the second cooking cavity 102, and the center of the first cooking cavity 101 deviates from the center of the second cooking cavity 102 in a left-right direction; and correspondingly, the output shafts of the two driving components 240 are not located in a same vertical plane.

In the above technical solution, a bracket suitable for the motor is fixed to the outside of the housing 230, such that the installation stability of the driving component 240 is further improved. During installation, the bracket is fixed to the outside of the housing 230 with suitable screws.

Further, a rear cover plate 160 is detachably connected to the pot body 100, cold air cavities 170 are formed in the rear cover plate 160, and the cold air fans 210 are arranged in the corresponding cold air cavities 170; cold air outlets 171 are formed in side walls of the cold air cavities 170 and connected to the cold air ducts 103; exhaust outlets 107 are formed in a side wall of the pot body 100 and connected to the cold air ducts 103, and as shown in FIG. 1, the exhaust outlets 107 are located on a right side of the pot body 100.

The number of the cold air cavities 170 is two, that is, the cold air cavities 170 correspond to the two cold air fans 210 respectively; and the cold air outlets 171 are located at the tops of the cold air cavities 170, two partition ribs 161 are arranged on the rear cover plate 160, each partition rib 161 partitions the corresponding cold air outlet 171 into two portions with opposite flow directions, such that the temperature of structures on left and right sides and the temperature between the first cooking cavity 101 and the second cooking cavity 102 can be decreased under the action of an air flow.

Further, multiple suction holes 162 are formed in the rear cover plate 160 and correspond to the cold air fan of the fan assembly located above, that is, the cold air fan sucks air from the suction holes 162 and then blows cold air to the left and right sides of the cooking system as well as the top of the cooking system, thus further reducing the structural temperature of the cooking system. Structural holes are formed in rear walls of the first cooking cavity 101 and the second cooking cavity 102 and connected to the corresponding hot air fans 220.

An air deflector 180 is arranged at a joint between the air director 150 and the upper duct plate 131. In this embodiment, the air deflector 180 divides the joint between the air director 150 and the upper duct plate 131 into two portions to disperse incoming air, that is, the air is prevented from being excessively concentrated when flowing through the area between the upper duct plate 131 and the lower duct plate 132, such that air can enter the first cooking cavity 101 and the second cooking cavity 102 relatively uniformly so as to be heated uniformly, that is, food to be cooked can be heated uniformly.

To discharge surplus air or moisture out of the first cooking cavity 101 and the second cooking cavity 102 in use, in this embodiment, a hot air outlet passage 134 is connected between the two duct plate assemblies 130, and the hot air outlet passage 134 is provided with a hot air outlet 135 connected to the outside.

Specifically, the hot air outlet passage 134 is connected between the two upper duct plates 131, a main structure of the hot air outlet passage 134 is located in a receiving cavity 109, and the hot air outlet 135 is located in the back of the cooking system. To prevent an upper hot air flow and a lower hot air flow in the hot air outlet passage 134 from being counteracted by each other and flowing aimlessly, a partition portion 136 is arranged in the hot air outlet passage 134 to approximately partition the space in the hot air outlet passage 134 into an upper portion and a lower portion.

The capacity of the first cooking cavity 101 is greater than the capacity of the second cooking cavity 102, the receiving cavity 109 is formed between the second cooking cavity 102 and the pot body 100, and an operation panel 190 corresponding to the receiving cavity 109 is correspondingly mounted on the pot body 100, that is, the receiving cavity 109 is located on the back of the operation panel 190.

It should be noted that other structures in the cooking system and corresponding control structures in the scheme of this embodiment belong to the prior art, and these structures and principles will not be detailed here.

The embodiments of the present application are described above, and common sense such as known specific technical solutions and/or features in the embodiments are not described in detail. It should be noted that for those skilled in the art, various transformations and improvements can be made without departing from the technical solutions of the present application, and all these transformations and improvements should also fall within the protection scope of the present application and will not affect the implementation effect of the present application and the practicability of the patent. The protection scope of the application should be defined by the claims, and the specific embodiments and other contents in the description are used for explaining the claims.

## Claims

1. A cooking system, comprising a pot body, the pot body having a first cooking cavity and a second cooking cavity which are arranged with one below the other, wherein:
fan assemblies are correspondingly mounted on a back of the first cooking cavity and a back of the second cooking cavity, and each fan assembly comprises a cold air fan and a hot air fan;
cold air ducts connected to an outside are formed between the first cooking cavity and the pot body and between the second cooking cavity and the pot body; hot air ducts are formed between the first cooking cavity and an air fryer placed in the first cooking cavity and/or between the second cooking cavity and an air fryer placed in the second cooking cavity;
part of the air is drawn into the fan assemblies from a bottom of the pot body and delivered into the cold air ducts via the cold air fans; and
the hot air fans are used for driving air in the hot air ducts to circulate between the air fryers and the hot air ducts to cook food.

2. The cooking system according to claim 1, wherein duct plate assemblies are arranged at a top of the first cooking cavity and a top of the second cooking cavity, heating elements are arranged in the duct plate assemblies, and air directors are connected between the fan assemblies and the duct plate assemblies.

3. The cooking system according to claim 2, wherein each duct plate assembly comprises an upper duct plate and a lower duct plate, and air is blown into the first cooking cavity or the second cooking cavity sequentially through the corresponding air director, the corresponding upper duct plate and the corresponding lower duct plate.

4. The cooking system according to claim 2, wherein each fan assembly comprises a housing, a driving component is mounted in the housing, the cold air fan and the hot air fan are located on two sides of the driving component respectively, and the hot air fan is arranged close to the first cooking cavity or the second cooking cavity and located in the corresponding air director; and
air inlets are formed in the bottom of the pot body and connected to a side of one housing to form an air inlet path.

5. The cooking system according to claim 4, wherein a rear cover plate is detachably connected to the pot body, cold air cavities are formed in the rear cover plate, and the cold air fans are arranged in the corresponding cold air cavities;
cold air outlets are formed in side walls of the cold air cavities and connected to the cold air ducts; and
exhaust outlets are formed in a side wall of the pot body and connected to the cold air ducts.

6. The cooking system according to claim 1, wherein a partition is arranged in the pot body, and the first cooking cavity and the second cooking cavity are located above and below the partition respectively.

7. The cooking system according to claim 5, wherein partition ribs are arranged on the rear cover plate, and each partition rib partitions the corresponding cold air outlet into two portions with opposite flow directions.

8. The cooking system according to claim 3, wherein air deflectors are arranged at joints between the air directors and the upper duct plates.

9. The cooking system according to claim 1, wherein a capacity of the first cooking cavity is greater than a capacity of the second cooking cavity, a receiving cavity is formed between the second cooking cavity and the pot body, and an operation panel corresponding to the receiving cavity is correspondingly mounted on the pot body.

10. The cooking system according to claim 3, wherein a top of the upper duct plate is inclined to allow a flow path of part of the air to deflect towards the first cooking cavity or the second cooking cavity, and the upper duct plate deviates from the corresponding heating element.

11. The cooking system according to claim 2, wherein a hot air outlet passage is connected between the two duct plate assemblies, and the hot air outlet passage is provided with a hot air outlet connected to the outside.

12. The cooking system according to claim 5, wherein suction holes are formed in the rear cover plate and correspond to the cold air fan of the fan assembly located above.
